# EUROPEAN PATENT APPLICATION

(11) **EP 1 079 424 A1**
(43) Date of publication of application: **28.02.2001**
(21) Application number: 99116265.2
(22) Date of filing: 18.08.1999
(51) Int. Cl.: H01L 21/302, H01L 21/8242

(54) **A method for forming a deep trench in a semiconductor substrate**

(71) Applicant: MOTOROLA, INC., Schaumburg, IL 60196 (US); Infineon Technologies AG, 81541 München (DE); Semiconductor 300 GmbH & Co. KG, 01074 Dresden (DE)
(72) Inventor: Morgenstern, Thomas, 01109 Dresden (DE); Mautz, Karl Emerson, 01326 Dresden (DE)
(74) Representative: Richardt, Markus Albert

(57) **Abstract**

The following invention provides a method for forming a deep trench (5) in a semiconductor substrate (10), particularly when forming a trench capacitor using said trench (5), comprising the steps of: providing a mask (20, 30) on said semiconductor substrate (10) for defining the location of said trench (5); forming a first region (5a) of said trench (5) in said semiconductor substrate (10) by a first etch step; introducing impurities in a region (10b) of said semiconductor substrate (10) lying under said formed first region (5a) of said trench (5), wherein said impurities are selected such that they improve the etchability of said region (10b) of said semiconductor substrate (10); and forming a second region (5b) of said trench (5) in said region (10b) of said semiconductor substrate (10) containing said impurities by a second etch step.

## Description

The present invention relates to a method for forming a deep trench in a semiconductor substrate, and in particular used for forming a trench capacitor including said deep trench.

It should be mentioned that the term semiconductor substrate as used herein is to be understood in a general form and should include all substrates known in semiconductor process technology, such as wafer substrates, layer substrates, well substrates, epitaxial substrates, etc..

Although in principle applicable to arbitrary deep trenches (DT), the present invention and its underlying problems will be discussed with respect to trench capacitors.

Integrated circuits (ICs) or chips use capacitors for storing charges. An example of an IC which uses capacitors for storing charges is a storing IC such as a chip for a DRAM. The charge state ("0") or ("1") in the capacitor represents a data bit.

A DRAM chip comprises an array of memory cells which are connected in form of columns and rows. Usually the row connections are called word lines and the column connections are called bit lines. Reading data from said memory cells or writing data in said memory cells is achieved by activating corresponding word lines and bit lines.

Usually such a DRAM memory cell comprises a transistor connected to said capacitor. The transistor comprises two diffusion regions which are separated by a channel above which a gate is arranged. Dependent on the direction of current flow, one diffusion region is called drain and the other source. The terms drain and source regarding said diffusion regions in process technology are mutually exchangeable. The gates are connected to a word line, and one of the diffusion regions is connected to a bit line. The other diffusion region is connected to said capacitor. Application of an appropriate voltage to the gate switches on said transistor, enables a current flow between said diffusion regions through said channel so as to form a connection between the capacitor and the bit line. Turning off said transistor cuts off this connection by interrupting the current flow through the channel.

The charge stored in said capacitor diminishes with time due to an inherent leakage current. Before said charge reaches an undetermined level (falls below a certain threshold) said storage capacitor has to be refreshed.

The ongoing efforts for miniaturisation of said memory devices promotes the design of DRAMs having higher density and smaller characteristic magnitude, i.e. smaller memory cell area. For forming memory cells having a smaller surface area, smaller components such as capacitors are used.

However, the use of smaller capacitors results in a smaller storage capacity which negatively influences the performance and applicability of said memory device. For example, sense amplifiers require a sufficient signal level for reliably reading the information in said memory cells. The ratio of memory capacity and bit line capacity is crucial for the determination of the signal level. If the storage capacity gets too small, said ratio may be too small for generating a suitable signal. Also a smaller memory capacity requires a higher refresh frequency.

A capacitor type which is usually used in DRAMs is the trench capacitor. A trench capacitor has a three-dimensional structure which is formed in a silicon substrate. An enhancement of the volume or the capacity of the trench capacitor may be achieved by deeper etching into said substrate. In this case, the enhancement of the capacity of said trench capacitor does not effect an enhancement of the surface occupied by said memory cell.

A usual trench capacitor contains a deep trench etched into said substrate, the depth being 5 - 7 µm for example. Said trench is usually filled with p⁺ or n⁺ doped polysilicon serving as a capacitor electrode. The second capacitor electrode is said substrate or a buried plate. A capacitor dielectric, which for example includes silicon nitride, is usually taken as insulating material between said two capacitor electrodes.

The deep trenches in question are usually formed by dry etch or plasma etch processes, the essential parameters thereof being the etch rate or the required etching time and the etching chemistry. In these etching processes an homogeneous profile should be formed, which requirement, however, holds down the etching rate, and particularly if the depth of the deep trench is enhanced.

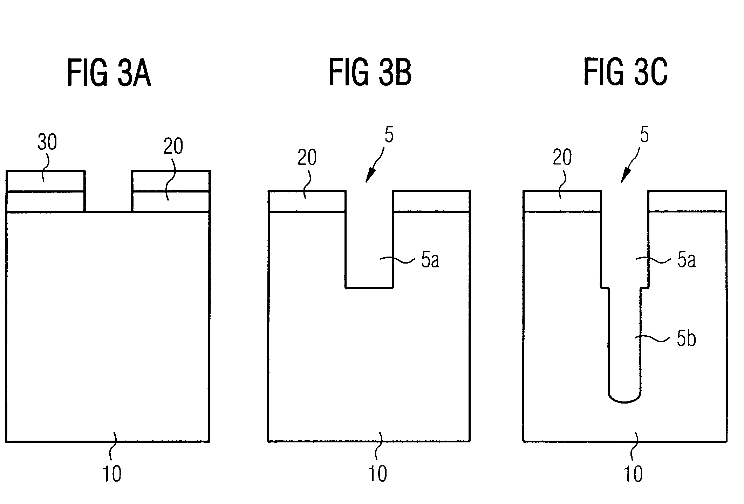

Fig. 3a) to c) shows the process step sequence of a usual method for forming a deep trench in a semiconductor substrate.

In Fig. 3b) and c) reference sign 5 denotes a deep trench, 10 a semiconductor substrate made of silicon, 20 a hard mask formed thereon and 30 a photoresist mask formed on said hard mask.

The photoresist layer 30 is structured using common photolithographic techniques. The hard mask layer 20 is then etched in a dry etch, and thereafter the photoresist layer 30 is stripped. Thus, a region is defined in which said trench 5 has to be formed.

In a usual process, the structure according to Fig. 3a is provided in multiple form on a wafer, and said wafer is put into a per se known dry etch chamber, namely alone or together with other wafers. In said dry etch chamber a first etch step, f.e. using HBr-chemistry or Chlorine bearing gases, is performed in order to form an upper region 5a of said trench, as illustratd in Fig. 3b. The upper region usually slightly narrows from the top to the bottom (includes a taper).

In a second etch step using the same etch chemistry, however, different etch chamber conditions regarding pressure, energy, etc., the lower region 5b of the trench 5 is formed, as illustrated in Fig. 3c. However, the etch rate decrease by about 33 to 50 % in said second etch step.

The profile of the deep trench 5 generated in this way comprises the lower region 5b having a vertical form and the upper region 5a having a controllable taper of approximately 88° (not shown in the Figure), the depth being 7 pm, f.e.

The etch methods known in the state of the art use a predetermined etch chemistry and etch chamber hardware configuration. Even with this predetermined parameters the process window is small. A repeatable trench depth is difficult to achieve or to control.

Typical problems in these known trench etch processes are also low etch rates (the etch rate diminishes with increasing trench depth), side pockets at the upper edge of said trench or pin holes in the lower trench region. Moreover, a plasma clean of said etch chamber is required after each wafer or each wafer batch in said known method. For said clean the etch chemistry is changed, for example to a fluorine chemistry, and using a corresponding clean etch step the impurities are removed from said etch chamber. This influences the throughput and the lifetime of said etch chamber essentially.

Therefore, it is an object of the present invention to improve the known method regarding trench depth and to provide an enhanced etch rate without using more aggressive or more unstable plasma etch processes.

According to the present invention this object is achieved by the method defined in claim 1.

The idea underlying the present invention is to modify the silicon substrate within the trench between individual etch steps by certain mechanisms in order to enhance or improve the etchability. This may be achieved by changing the surface state of the corresponding substrate region or by weakening the crystal (film) structure. Both the depth and the profile in the lower region of the deep trench may be improved in this controllable way. The used impurities are selected such that they cause the desired effects. Typically As, P or B are used in order to change the silicon lattice. B is most suited for achieving a larger depth, and As or P may be used in order to precisely aim at certain depths. Also less common ions may be implanted if they produce the desired characteristics. For ion milling which is a physical sputtering process, heavy ions such as Ar, may be used.

In comparison to known solutions, the method according to the invention exhibits the advantage that the etch rate is improvable using the existing etch chemistry/hardware combination, and only the semiconductor substrate is modified in situ or ex situ in order to enhance the etch rate and to improve the etch profile.

The present solution allows more consistent etch depths as function of the life time of the chamber and trenches deeper than the ones which may be achieved at present (for example deeper than 10 µm), and having a desired profile which may be precisely predetermined by simulations.

The advantages besides the improved etch depth and etch rate are a more homogenous profile and an improved homogeneity. An improved etch depth will improve the performance of a corresponding trench capacitor and will enable a further miniaturisation of the trench capacitor memory cell.

The influence of the cleanliness of said chamber (chamber life time) on the performance of the trench depth should be minimised. The clean cycles are extended. The etch processes for forming said deep trenches may be optimised so as to improve the profile and to minimise defect formations. Finally, the process is more easy to optimise and to control, such as a trench etch process where different etch rates are used. Another advantage is the better repeatable trench profile.

In every application, the influence of the introduced impurity species on the performance of the corresponding semiconductor device has to be investigated, particularly regarding ions which are present in higher depths or laterally diffused into the substrate. The implantations may be optimised in order to suppress such negative effects, if any, namely by suitably selecting ion species, dose, energy, current and so on.

The general competitive advantage of the process scheme comprises the improved trench depth plus the ability to provide deeper trench capacitors having improved performances and the potential for increased miniaturisation and additional shrink generations without major redesigns. This specifically targets DRAM manufacturers, but would also include any integrated circuit producer of logic with embedded DRAM.

Preferred embodiments are part of the dependent claims.

According to a preferred embodiment the introducion of impurities is performed into another region of said semiconductor substrate lying under the latest formed region of said trench, said impurities being selected such that they improve the etchability of said further region of said semiconductor region. Thereafter another region of said trench is formed in said further region of said semiconductor substrate containing said impurities by means of another etch process. In other words, the cycles introducing the impurities and etching of the region containing the impurities can be repeated many times.

According to another preferred embodiment, introducing the impurities is performed by an ion implantation using said mask. Preferably this is an ex situ ion implantation having a profile according to the lower region of said deep trench in a predetermined trench depth starting from a point where the etch rate of the standard process starts to decrease. A certain prolongation of the cycle time of the process would be caused by such an ex situ step. The wafers have to be unloaded from the etch chamber and have to be processed in an ion implanter. This would cause an extra step. However these steps may be performed relatively quick (minutes per wafer) and minimise the influence on the production with optimised manufacturing sequence and optimised arrangement of said manufacturing devices. Manufacturing devices may be multifunctionally designed in future such that on a main frame or cluster platforms etch chambers and implanters are provided in common (then the wafers may transported from one chamber to another under vacuum and very quickly).

According to another preferred embodiment introducing of impurities is performed by an ion bombardment using said mask. This is preferably done by an in situ ion bombardment (also called ion milling) for roughening the silicon substrate without influencing the mask film (low chemical reactivity or specific silicon reactivity of said ions).

According to another preferred embodiment, introducing said impurities is achieved by laser doping using said mask. Also said laser doping may preferably be done in situ.

According to another preferred embodiment the semiconductor substrate is a silicon substrate and said impurities comprise phosphorus, arsenic or boron. According to common knowledge the integration of said impurity atoms weakens the silicon lattice and facilitates etching and enhances the etching rate respectively.

According to another preferred embodiment the first etch step is a plasma etch step.

According to another preferred embodiment the second etch step is a plasma etch step. Suitably, the conditions in both etch steps are the same.

According to another preferred embodiment the first etch step is a plasma etch step to be performed in an etch chamber, and the introducion of impurities is performed in situ. In other words, the etch chamber comprises a means by which the introducion of impurities may be achieved between said etch steps, for example an ion bombardment means, a laser doping means or even a beam nozzle of an implanter to be directed to said wafer.

According to another preferred embodiment, in said etch chamber an ion bombardment is performed by applying a DC-bias in said etch chamber in situ. This brings up the advantage that the wafer can stay in said etch chamber and only the plasma has to be changed and the DC-bias has to be turned on in order to achieve an anisotropic ion bombardment.

According to another preferred embodiment, said ion bombardment is performed by means of inert ions, preferably noble gas ions such as argon. This has the effect that the surface of the corresponding region is roughened without changing the conductivity of the substrate in said region. Moreover, this process will not erode the hard mask layer.

According to another preferred embodiment the mask comprises a hard mask on the semiconductor substrate and a photoresist mask arranged thereon.

According to another preferred embodiment before forming said first region of said trench in said semiconductor substrate by said first etch step, introducing of impurities in the corresponding region of said semiconductor substrate is performed, said impurities being selected such the etchability of the corresponding region of said semiconductor substrate is improved. In other words, even before the first etch step, an introducion of impurities may be performed, although not really required because of the fast etch rate of the standard process just below the surface of the semiconductor substrate.

According to another preferred embodiment, a less aggressive and more controlable Chlorine or Fluorine bearing gas plasma chemistry or a wet etch may be used in said second etch step in comparison to said first etch step. This has the advantage that problems with pinholes and sidepockets may be avoided better. Also, the deep trench profile and dimensions may be modified, if desired.

Embodiments of the present invention are illustrated in the accompanying drawings and described in detail in the following.

In the Figures:
- Fig. 1: shows a process sequence of a first embodiment of the method according to the invention for forming a deep trench in a semiconductor substrate;
- Fig. 2: shows a schematic illustration of said etch chamber for application in a second embodiment of the method according to the invention; and
- Fig. 3: shows a process step sequence of a usual method for forming a deep trench in a semiconductor substrate.

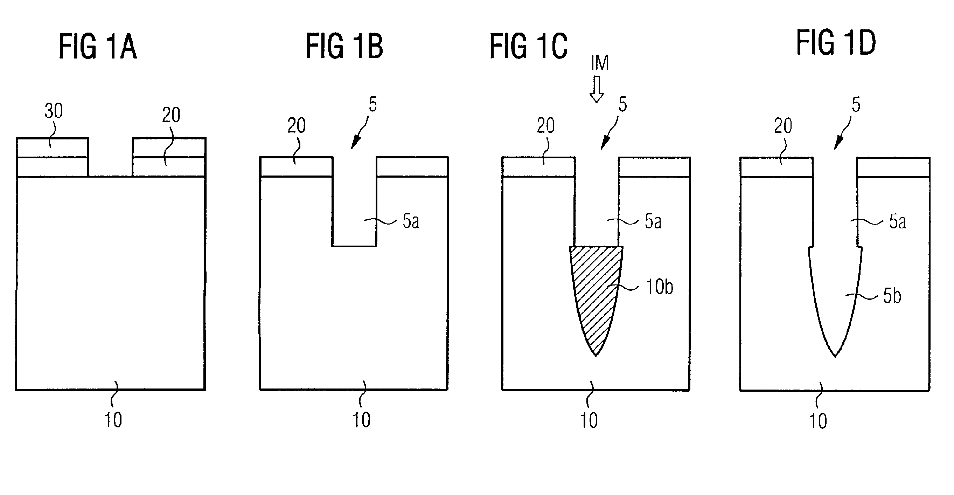

Fig. 1 shows the process step sequence of a first embodiment of the method for forming a deep trench in a semiconductor substrate according to the invention.

In this example, the trench 5, for example used for a trench capacitor, is formed in a silicon semiconductor substrate 10. The substrate 10 is lightly doped with p-type dopants (p⁻), such as boron (B).

In Fig. 1, reference sign 5 denotes a deep trench, 10 said semiconductor substrate made of silicon, 20 a hard mask formed thereon and 30 a photoresist mask formed on said hard mask 20.

The photoresist layer 30 is structured using common photolithographic techniques. The hard mask layer 20 is then etched in a dry etch, and thereafter the photoresist layer 30 is stripped. Thus, a region is defined in which said trench 5 has to be formed.

In the process according to this embodiment the structure of Fig. la is provided in multiple form on a wafer, and said wafer alone or a plurality of wafers is put into the known dry etch chamber. In the dry etch chamber, a first etch step is performed, f.e. using HBr chemistry in order to form an upper region 5a of said trench 5, as shown in Fig. lb. The first etch step is performed until a depth is reached where the etch rate of said standard etch process starts to heavily decrease, i.e. approximately 3-4 µm.

Thereafter, the wafer is taken out of the dry edge chamber, and in accordance with Fig. lc an ion implantation IM is performed for introducing impurities in a region 10b of said semiconductor substrate 10 lying under said first region 5a of said trench 5. The introduction of impurities is performed by an ion implantation of boron using said mask 20 and 30. This ex situ ion implantation is performed in accordance with the exemplary bulb-shape profile according to the lower region 5b of said trench 5.

The ion implantation parameter, such as energy and dose, are determined in advance by a simulation under consideration of said desired profile. Therefore, usually a compromise between scattering and penetration depth has to be found. Typical energies are relatively low and lie in the range of some MeV preferably 1-10 MeV and most preferably 1-3 MeV. Typical doses are 10¹²-10¹⁶ ions/cm².

The implanted B ions weaken the silicon lattice and effect an enhancement of the etch rate for the standard etch process in the region 10b of said semiconductor substrate lying under the first region 5a of said trench 5.

Then the wafer is transported back to the etch chamber and in accordance with Fig. ld forming of the second region 5b of said deep trench 5 in the region 10b of the semiconductor substrate 10 containing said impurities is achieved by a second etch step using the same HBr plasma etch process. Alternatively, a less aggressive more controlable Chlorine or Fluorine bearing gas plasma chemistry or a wet etch may be used in said second etch step.

Thus, a deep trench 5 of typically up to 10 µm depth may be formed in principle. Certainly, the implantation and etch steps may be repeatedly performed in order to achieve even higher trench depths.

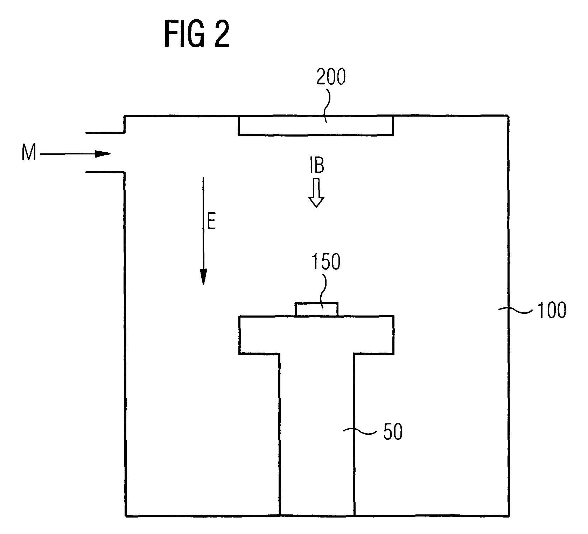

Fig. 2 shows a schematic illustration of said edge chamber to be used in a second embodiment of the method according to this invention.

In Fig. 2, reference sign 100 denotes a plasma edge chamber, 50 a wafer table, 150 a wafer having a upwardly directed pattern according to Fig. 1a, 200 a DC-bias means for applying an electrical field E in the direction of the wafer 150, IB an ion bombardment beam and M an etchant supply.

In this second embodiment, in said etch chamber 100 an ion bombardment IB is achieved by applying said DC-bias using said DC-bias means 200 in said etch chamber in situ.

In other words, after said first etch step the E-field is switched on and the etchant is changed, for example to a boron-containing gas and said boron ions are accelerated in said trench so as to be introduced in the region 10b of said semiconductor substrate 10 lying under the first region 5a of said trench 5 where they enhance the etchability of said region 10b.

Thereafter, the second etch step is performed as in the first embodiment. In this second embodiment, it is even simpler to repeat the impurity introduction and etch steps several times, because the wafer or wafers may be left in the etch chamber 100.

Although the present invention has been described with regard to specific embodiments, it is not limited thereto, but may be modified in many ways.

Particularly, the described materials are only examples and replaceable by other suitable materials. The same is true for the etch processes.

Moreover, also before the first etch step an introduction of impurities may be performed in the upper trench region.

Although the second etch step has been described as plasma etch step in the foregoing, in principle the second etch step may be a wet etch step, particularly if it is the last trench etch step.

The solution according to the invention may have a combination of different techniques of the proposed steps of introducing said impurities or have repeated cycles in order to improve the results.

Finally, the invention may be used for other semiconductor substrate layers, such as contact etch in oxides where large aspect ratios cause a significant decrease in the etch rate.

### REFERENCE SIGNS

- 5: deep trench
- 10: semiconductor substrate
- 20: hard mask
- 30: photoresist mask
- 5a: upper region of trench 5
- 5b: lower region of trench 5
- 10b: lower substrate region
- 100: plasma etch chamber
- 50: wafer table
- 150: wafer
- IM: ion implantation
- IB: ion bombardment
- E: electrical field
- M: etchant

## Claims

1. A method for forming a deep trench (5) in a semiconductor substrate (10), particularly when forming a trench capacitor using said trench (5), comprising the steps of :
providing a mask (20, 30) on said semiconductor substrate (10) for defining the location of said trench (5);
forming a first region (5a) of said trench (5) in said semiconductor substrate (10) by a first etch step;
introducing impurities in a region (10b) of said semiconductor substrate (10) lying under said formed first region (5a) of said trench (5), wherein said impurities are selected such that they improve the etchability of said region (10b) of said semiconductor substrate (10); and
forming a second region (5b) of said trench (5) in said region (10b) of said semiconductor substrate (10) containing said impurities by a second etch step.

2. The method according to claim 1, comprising the steps of:
introducing impurities in another region of said semiconductor substrate (10) lying under the latest formed region of said trench (5), said impurities being selected such that they improve the etchability of said further region of said semiconductor substrate (10); and
forming another region of said trench (5) in said further region of said semiconductor substrate (10) containing said impurities by another etch step.

3. The method according to claim 1, wherein said introducing of impurities is achieved by means of an ion implantation using said mask (20, 30).

4. The method according to claim 1, wherein said introducing of impurities is achieved by means of an ion bombardment using said mask (20, 30).

5. The method according to claim 1, wherein said introducing of impurities is achieved by laser doping using said mask (20, 30) .

6. The method according to one of claims 3 to 5, wherein said semiconductor substrate (10) comprises a silicon substrate and wherein said impurities comprise phosphorus, arsenic , or boron.

7. The method according to one of the preceding claims wherein said first etch step comprises a plasma etch step.

8. The method according to one of the preceding claims, wherein said second etch step comprises a plasma etch step.

9. The method according to claim 1, wherein said first etch step is a plasma etch step which is performed in an etch chamber (100), and wherein the introduction of impurities is performed in situ.

10. The method according to claim 9, wherein in said etch chamber (100) an ion bombardment is performed in situ by applying a DC-bias.

11. The method according to claim 1, wherein said ion bombardment is performed by means of inert ions, particularly noble gas ions such as argon.

12. The method according to claim 1, wherein said mask comprises a hard mask (20) arranged on said semiconductor substrate (10) and a photoresist mask (30) arranged on said hard mask (20).

13. The method according to one of the preceding claims, wherein before forming said first region (5a) of said trench (5) in said semiconductor substrate (10) by said first etch step, an introduction of impurities in the corresponding region of said semiconductor substrate (10) is performed, said impurities being selected such that they improve the etchability of the corresponding region of said semiconductor substrate (10).

14. The method according to one of the preceding claims, wherein a less aggressive and more controlable Chlorine or Fluorine bearing gas plasma chemistry or a wet etch may be used in said second etch step in comparison to said first etch step.

## Amended claims

### Amended claims in accordance with Rule 86(2) EPC.

**1.** A method for forming a deep trench (5) in a semiconductor substrate (10), particularly when forming a trench capacitor using said trench (5), comprising the steps of:
providing a mask (20, 30) on said semiconductor substrate (10) for defining the location of said trench (5);
forming a first region (5a) of said trench (5) in said semiconductor substrate (10) by a first etch step being a plasma etch step performed in an etch chamber (100);
introducing impurities in a region (10b) of said semiconductor substrate (10) lying under said formed first region (5a) of said trench (5), wherein said impurities are selected such that they improve the etchability of said region (10b) of said semiconductor substrate (10) and wherein introducing impurities is performed in situ by ion bombardment; and
forming a second region (5b) of said trench (5) in said region (10b) of said semiconductor substrate (10) containing said impurities by a second etch step.

**2.** The method according to claim 2, wherein in said etch chamber (100) said ion bombardment is performed by applying a DC-bias.

**3.** The method according to claim 1, wherein said introducing of impurities is achieved by laser doping using said mask (20,30).

**4.** The method according to claim 1, wherein said ion bombardment is performed by means of inert ions, particularly noble gas ions such as argon.

**5.** The method according to claim 1 wherein a less aggressive and more controllable Chlorine or Fluorine bearing gas plasma chemistry is used in said second etch step in comparison to said first etch step.

**6.** The method according to claim 1 wherein a wet etch is used in said second etch step.
